# FASCICULE DE BREVET EUROPEEN

(11) **EP 4 211 287 B1**
(45) Date de publication et mention de la délivrance du brevet: **02.10.2024**
(21) Numéro de dépôt: 21778356.2
(22) Date de dépôt: 06.09.2021
(51) Int. Cl.: C23C 14/08, F21S 43/50, F21S 41/20, C23C 14/00, C23C 14/06, C23C 14/14, C23C 14/32, C23C 14/58

(54) **PIÈCE DE VÉHICULE AUTOMOBILE COMPRENANT UN REVÊTEMENT D'OPACIFICATION, PROCÉDÉ DE FABRICATION ASSOCIÉ ET DISPOSITIF LUMINEUX LA COMPRENANT**
KRAFTFAHRZEUGTEIL MIT EINER TRÜBUNGSBESCHICHTUNG, ZUGEHÖRIGES HERSTELLUNGSVERFAHREN UND BELEUCHTUNGSVORRICHTUNG DAMIT
MOTOR VEHICLE PART COMPRISING AN OPACIFICATION COATING, ASSOCIATED PRODUCTION METHOD AND LIGHTING DEVICE COMPRISING SAME

(30) Priorité: 07.09.2020 FR 2009074
(43) Date de publication de la demande: 19.07.2023
(73) Titulaire: VALEO VISION, 93012 Bobigny Cedex (FR)
(72) Inventeur: CORBINEAU, Julien, 49000 Angers (FR); PAPIN, Laurent, 49000 Angers (FR)
(74) Mandataire: Valeo Visibility
(86) Numéro de dépôt international: PCT/EP2021/074524
(87) Numéro de publication internationale: WO 2022/049296

(56) Documents cités:
- EP-A1- 2 169 298
- EP-A1- 3 263 735

## Description

### DOMAINE TECHNIQUE

La présente invention concerne le domaine des pièces de véhicule automobile. Elle trouve pour application particulièrement avantageuse le domaine de la signalisation et de l'éclairage de véhicule automobile.

### ETAT DE LA TECHNIQUE

Pour présenter un motif ou un élément visuel en surface d'une pièce de véhicule automobile, on peut employer un revêtement opacifiant recouvrant en partie la surface de la pièce. Le motif ou l'élément visuel apparaît alors par contraste entre le revêtement opacifiant et la surface de la pièce.

Dans des dispositifs d'éclairage et/ou de signalisation par exemple, ce revêtement peut par exemple être disposé sur un réflecteur ou sur un enjoliveur du dispositif, encore appelé couramment masque (pouvant être traduit en anglais par le terme « *bezel* »). Un motif lumineux peut alors apparaître lors de l'allumage du dispositif, par exemple pour former une signature lumineuse d'un modèle de véhicule automobile.

Une solution généralement employée consiste à appliquer une couche de peinture noire sur la surface de la pièce. Cette couche est ensuite gravée, par exemple par ablation laser, pour faire apparaître le motif. Toutefois, l'épaisseur typique d'une couche de peinture est d'environ 30 µm, ce qui nécessite un temps d'ablation laser long et donc un investissement lourd en équipement d'ablation laser. En outre, la peinture en-traine une émission important de composés organiques volatils, nuisibles pour l'environnement.

En alternative, il est connu du document JP 2008077929 (A) un dispositif lumineux de véhicule automobile dans lequel un substrat en résine est recouvert d'un revêtement formé d'une couche mince de fer ou d'un alliage de fer, présentant une épaisseur inférieure ou égale à 10 nm. L'ensemble formé par le substrat et la résine sont traités par un recuit thermique afin de moduler la couleur du revêtement par oxydation. Un recuit thermique peut toutefois induire des fissures dans le revêtement, voire endommager le substrat. Pour éviter cela, l'épaisseur du revêtement est limitée, ce qui limite ses performances d'opacification.

Un objet de la présente invention est donc de proposer une pièce de véhicule automobile comprenant un revêtement d'opacification amélioré, fiable et reproductible.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit une pièce de véhicule automobile comprenant :
- un corps à base d'un polymère présentant une surface,
- un revêtement d'opacification recouvrant au moins une portion de la surface.

Avantageusement, le revêtement :
- est formé d'au moins une couche mince à base de fer et comprenant au moins un parmi un oxyde de fer et un nitrure de fer, et
- présente une épaisseur supérieure ou égale à 100 nm sur au moins 50 % de l'au moins une portion de la surface.

Avantageusement, le revêtement présente une absorption d'un rayonnement lumineux incident sensiblement supérieure à 70%, préférablement sensiblement supérieure à 80%, et plus préférentiellement encore sensiblement supérieure à 90 %, du rayonnement lumineux incident. Ce rayonnement lumineux peut notamment être dans le domaine du visible. De façon alternative ou complémentaire, le revêtement présente une réflexion d'un rayonnement lumineux incident sensiblement inférieure à 30%, préférablement sensiblement inférieure à 20% et plus préférentiellement encore sensiblement inférieure à 10%, du rayonnement lumineux incident.

L'oxyde de fer et/ou le nitrure de fer, de couleur noire, permet d'opacifier la couche mince par rapport à une couche à base de fer non oxydé ni nitruré. En outre, cette opacification est ainsi assurée majoritairement par absorption d'un rayonnement lumineux incident, et non par réflexion de ce rayonnement. Le revêtement présente ainsi une couleur sombre et d'aspect non métallisé. La couche présente, sur une majorité de la surface revêtue, une épaisseur suffisante pour assurer une bonne opacification de la surface de la pièce. En outre, l'épaisseur de la couche permet d'assurer une bonne opacification pour un ensemble de pièces, malgré une éventuelle variation de l'épaisseur entre les pièces lors de leur fabrication. Le revêtement d'opacification est donc fiable et reproductible. Le matériau de la couche est en outre de coût réduit par rapport à celui de la peinture communément utilisée, réduisant ainsi le coût de la pièce.

De manière facultative, la pièce peut en outre présenter au moins l'une quelconque des caractéristiques suivantes qui peuvent être prises séparément ou en combinaison.

Le revêtement d'opacification peut être configuré de sorte à former au moins une zone opacifiée au niveau de l'au moins une portion de la surface, et au moins une zone non-revêtue. Le revêtement d'opacification recouvre uniquement en partie la surface du corps de la pièce, pour présenter un motif ou un élément visuel en surface de la pièce.

Le corps peut être au moins partiellement transparent, voire transparent. De façon synergique avec la caractéristique selon laquelle le revêtement d'opacification est configuré de sorte à former au moins une zone opacifiée au niveau de l'au moins une portion de la surface revêtue, et au moins une zone non-revêtue, la zone opacifiée permet de bloquer une transmission de lumière, et la zone non-revêtue forme une zone passante permettant une transmission de lumière. La zone non revêtue peut former un dioptre de sortie de lumière dans un dispositif lumineux.

La pièce peut être une pièce d'un dispositif d'éclairage et/ou de signalisation de véhicule, notamment un réflecteur, un enjoliveur ou une glace de fermeture.

Un deuxième aspect de l'invention concerne un dispositif lumineux de véhicule automobile comprenant une pièce de véhicule automobile selon le premier aspect, et une source de lumière, pour au moins une fonction choisie parmi une fonction d'éclairage et une fonction de signalisation.

Le corps de la pièce peut être au moins partiellement transparent, voire transparent, et le revêtement d'opacification peut être configuré pour former au moins une zone opacifiée au niveau de l'au moins une portion de la surface, et au moins une zone non-revêtue, et dans lequel la zone non-revêtue forme un dioptre de sortie de lumière.

La pièce peut être un enjoliveur d'un projecteur. Dans ce cas, et selon le paragraphe précédent, une fonction de signalisation peut être réalisée au travers de la zone non-revêtue. Par exemple, cette fonction de signalisation peut être un indicateur de direction, un feu de position (encore appelé « Parking Light » en langue anglaise) et/ou un feu de circulation diurne (encore appelé DRL, pour « Day Running Light » en langue anglaise).

Selon l'invention, la pièce peut être un élément d'un dispositif d'éclairage intérieur du véhicule, tel qu'un plafonnier ou une garniture lumineuse de l'habitacle, et/ou peut être un dispositif d'affichage d'information, notamment une planche ou une partie de planche de tableau de bord.

Un troisième aspect de l'invention concerne un véhicule équipé d'un dispositif lumineux selon le deuxième aspect de l'invention.

Un quatrième aspect de l'invention concerne un procédé de fabrication d'une pièce de véhicule automobile comprenant :
- une fourniture d'un corps à base d'un polymère présentant une surface,
- au moins un dépôt d'une couche mince à base de fer en atmosphère comprenant au moins un gaz réactif choisi parmi le dioxygène, le diazote, sur au moins une portion à opacifier de la surface, de sorte que la couche mince comprend au moins un parmi un oxyde de fer et un nitrure de fer, et présente une épaisseur supérieure à 100 nm sur au moins 50 % de l'au moins une portion de la surface, pour former un revêtement d'opacification.

Par réaction entre l'au moins un gaz réactif et le fer lors du dépôt, la couche mince obtenue comprend au moins un parmi un oxyde de fer et un nitrure de fer sans nécessiter de recuit supplémentaire. Dès lors, l'épaisseur de la couche peut être augmentée par rapport aux solutions existantes, ce qui permet d'assurer une bonne opacification tout en minimisant, voire évitant, le risque de fissure dans le revêtement et d'endommager le corps de la pièce. Le revêtement d'opacification obtenu est donc fiable et reproductible. En outre, ce procédé de fabrication présente un coût réduit par rapport à l'application d'une peinture, réduisant ainsi le coût de la pièce. Par ailleurs, l'émission de composés organiques volatils est réduite, voire évitée, lors du dépôt de la couche mince, voire en outre par l'absence de recuit, réduisant l'impact environnemental du procédé par rapport aux solutions existantes.

Selon un mode de réalisation, le procédé peut comprendre en outre au moins une étape parmi :
- une application d'un masque partiel de la surface préalablement au dépôt de la couche mince, suivi d'un retrait du masque après le dépôt de la couche mince, et
- une ablation laser d'une portion de la couche mince déposée.

Ainsi, le revêtement d'opacification obtenu forme au moins une zone opacifiée au niveau de l'au moins une portion à opacifier de la surface, et au moins une zone non-revêtue. De façon synergique avec l'ablation laser de la couche mince, l'épaisseur de la couche déposée permet de réduire par trois le temps d'ablation laser par rapport à l'ablation laser d'une couche de peinture.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
[Fig.1] La figure 1 représente une vue d'ensemble d'une pièce de véhicule automobile selon un mode de réalisation de l'invention.
[Fig.2] La figure 2 représente une vue schématique d'un dispositif lumineux d'un véhicule automobile selon un mode de réalisation de l'invention.
Les figures 3 à 9 illustrent schématiquement les étapes du procédé de fabrication de la pièce de véhicule automobile selon un mode de réalisation de l'invention, et plus particulièrement :

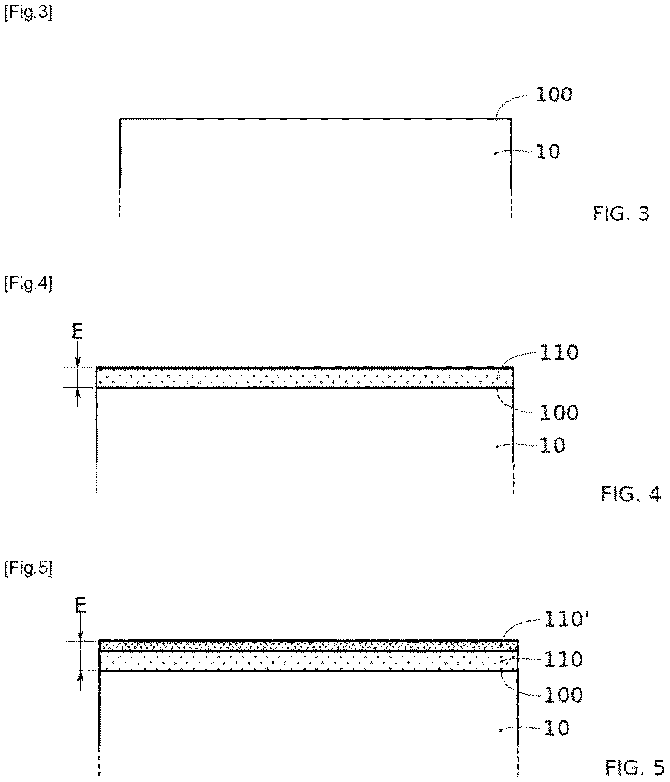

   - [Fig.3] la figure 3 illustre la fourniture d'un corps,
   - [Fig.4] les figures 4 à 6 illustrent le dépôt d'une couche mince selon différents exemples de réalisation,
[Fig.5]
[Fig.6]

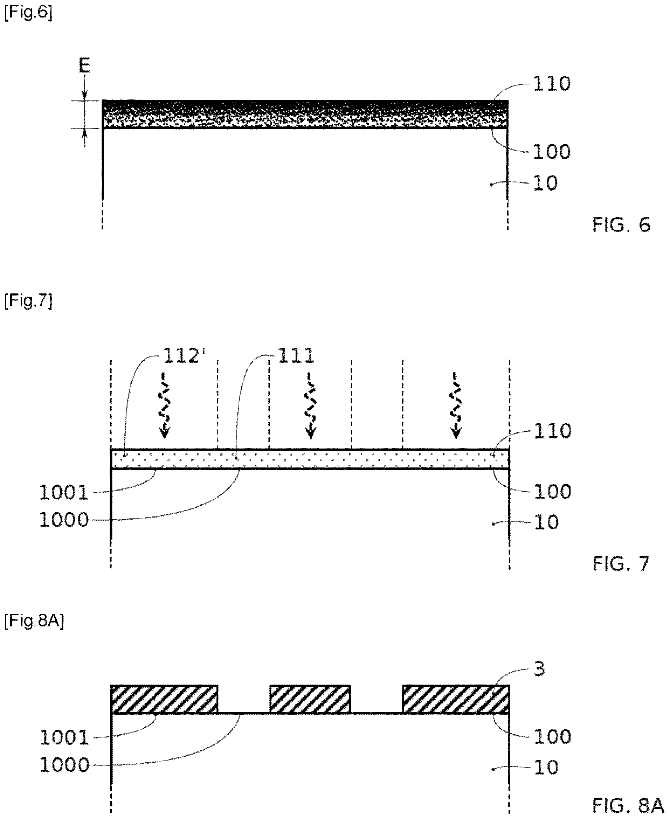

   - [Fig.7] la figure 7 illustre une ablation laser de la couche mince,
   - [Fig.8A] la figure 8A illustre l'application d'un masque sur la surface du corps fourni,

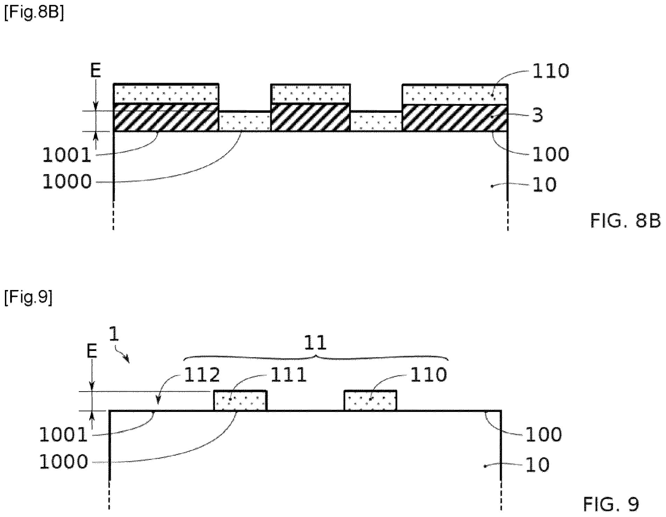

   - [Fig.8B] la figure 8B illustre le dépôt d'une couche mince suite à l'application du masque illustrée en figure 8A,
   - [Fig.9] La figure 9 représente une vue schématique de la pièce de véhicule automobile et du revêtement d'opacification obtenu après l'ablation laser illustrée en figure 7 ou après retrait du masque illustré en figure 8B, selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des couches minces et du corps ne sont pas représentatives de la réalité.

### DESCRIPTION DÉTAILLÉE

Avant d'entamer une revue détaillée de modes de réalisation de l'invention, sont énoncées ci-après des caractéristiques optionnelles du premier aspect de l'invention qui peuvent éventuellement être utilisées en association ou alternativement :
- le corps de la pièce présente une forme au moins selon deux dimensions, voire en trois dimensions,
- le corps est opaque,
- la surface du corps présente une couleur distincte d'une couleur du revêtement,
- la couche mince est directement en contact avec l'au moins une portion de la surface,
- la couche mince comprend au moins un parmi un oxyde de fer et un nitrure de fer sur toute son épaisseur.
- le revêtement d'opacification présente une épaisseur supérieure ou égale à 200 nm sur au moins 30 % de l'au moins une portion de la surface.
- le revêtement d'opacification présente une épaisseur inférieure ou égale à 1 µm, et de préférence inférieure ou égale à 600 nm,
- le revêtement d'opacification présente, sur au moins 50 % de l'au moins une portion de la surface, une couleur dans l'espace chromatique L*a*b*CIE 1976 défini par les paramètres L*, a* et b*, où :
   ∘ L* est compris entre 20 et 55, et de préférence entre 25 et 50,
   ∘ a* est compris entre -5 et +5,
   ∘ b* est compris entre -5 et +5.

Selon un exemple L est sensiblement égal à 30. Le revêtement d'opacification présente ainsi une couleur noire. Selon un exemple L est sensiblement égal à 45. Le revêtement d'opacification présente ainsi une couleur gris anthracite.

Des caractéristiques optionnelles du quatrième aspect de l'invention sont énoncées ci-après, qui peuvent éventuellement être utilisées en association ou alternativement :
- le dépôt de la couche mince est effectué à une pression comprise entre 10⁻⁴ mbar et 10⁻¹ mbar, et de préférence entre 10⁻³ mbar et 10⁻² mbar,
- l'atmosphère comprend du dioxygène à un taux compris entre 10 % et 100 %, et de préférence entre 20 % et 80 %,
- l'atmosphère comprend du dioxygène à un taux compris entre 10 % et 25 %, et de préférence entre 20 % et 25 %,
- l'atmosphère comprend du dioxygène à un taux compris entre 25 % et 100 %, et de préférence entre 25 % et 80 %,
- l'au moins un gaz réactif est dilué dans un gaz inerte, et par exemple dans de l'argon,
- l'au moins un gaz réactif est un mélange de dioxygène et du diazote, et plus particulièrement de l'air,
- le gaz réactif est uniquement du dioxygène,
- le dépôt de la couche mince est un dépôt physique en phase vapeur,
- le dépôt de la couche mince peut être un dépôt choisi parmi :
   ∘ un dépôt par évaporation thermique assisté par plasma,
   ∘ un dépôt physique en phase vapeur par faisceau d'électrons, (communément désigné en anglais par *Electron beam physical vapor deposition,* abrégé EBPVD)
   ∘ un dépôt par pulvérisation cathodique.

Il est précisé que dans le cadre de la présente invention, les expressions du type « égal, inférieur, supérieur » s'entendent de comparaisons pouvant accommoder certaines tolérances, notamment selon l'échelle de grandeur des valeurs comparées et les incertitudes de mesure. De façon similaire, l'expression « compris entre » désigne une gamme de valeur pouvant accommoder certaines tolérances, notamment selon l'échelle de grandeur des valeurs de la gamme et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

On entend par un élément à base d'un matériau A, un élément comprenant ce matériau A et éventuellement d'autres matériaux.

Dans la description qui suit, les épaisseurs sont généralement mesurées selon des directions perpendiculaires au plan de la face supérieure d'un substrat sur lequel la couche est disposée. Ainsi, les épaisseurs sont généralement prises selon une direction verticale sur les vues en coupe transversale représentées.

On entend par un élément « partiellement transparent », un élément configuré pour transmettre au moins partiellement des rayons lumineux incidents, et plus particulièrement au moins 20 %, voire au moins 40 %, voire au moins 50 %, voire au moins 70 %, des rayons lumineux incidents, ces rayons lumineux étant notamment dans le domaine du visible.

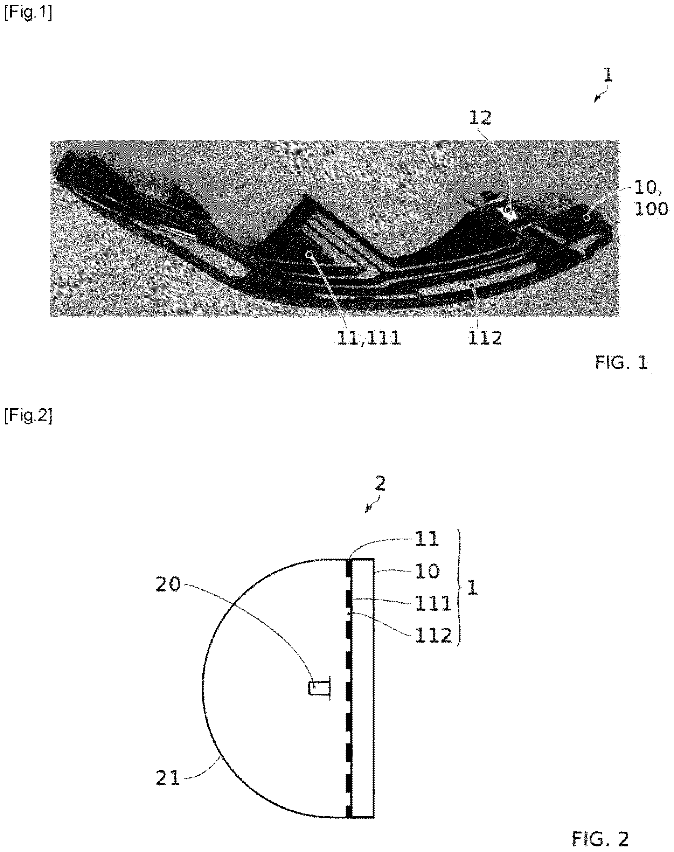

La pièce de véhicule automobile est maintenant décrite en référence à la figure 1, 2 et à la figure 9.

La pièce 1 de véhicule automobile comprend un corps 10. Le corps 10 présente une surface 100 dont au moins une portion 1000 est recouverte par un revêtement d'opacification 11, configuré pour masquer au moins en partie la surface 100 du corps 10. Ainsi, l'aspect extérieur ou les propriétés de la surface 100 peuvent être masqués, par exemple ses propriétés de diffusion, de réflexion et/ou de transmission de lumière. Plus particulièrement, le revêtement d'opacification recouvre au moins une portion 1000 de la surface 100, voire une pluralité de portions 1000, pour présenter un motif ou un élément visuel en surface 100 de la pièce 1.

Comme illustré en figures 1 et 9, le revêtement 11 peut former au moins une zone opacifiée 111, voire une pluralité de zones opacifiées, et au moins une zone non-revêtue 112, voire une pluralité de zones non-revêtues 112, à la surface 100 de la pièce 1. La zone opacifiée 111 et la zone revêtue 112 peuvent former par contraste un élément visuel ou un motif.

Comme illustré en figure 1, la pièce 1 peut être un enjoliveur de projecteur de véhicule, par exemple destiné à être placé en-dessous ou au-dessus des modules d'éclairage.

La pièce 1 peut être comprise dans un dispositif lumineux 2 de véhicule automobile, par exemple montée par un élément d'accroche 12. Le dispositif lumineux 2 comprend une source de lumière 20 et permet une fonction d'éclairage et/ou une fonction de signalisation.

Le dispositif lumineux 2 peut être un module de signalisation, intégré à un feu arrière de véhicule ou bien, comme ici, à un projecteur de véhicule, encore appelé phare.

Selon l'exemple non limitatif illustré en figure 2, le dispositif lumineux 2 est un module de signalisation intégré à un projecteur et comprenant une source de lumière 20, par exemple une diode électroluminescente, un réflecteur 21 disposé en regard de la source de lumière 20 et un dioptre de sortie.

Selon un exemple non illustré, la pièce 1 peut être le réflecteur 21 du dispositif lumineux 2. La zone opacifiée 111 du revêtement 11 peut empêcher la réflexion de lumière par le réflecteur 21 et la zone non-revêtue 112 peut permettre cette réflexion.

Selon un exemple illustré en figure 2, la pièce 1 peut être comprise dans, voire former, le dioptre de sortie du dispositif lumineux 2. La zone opacifiée 111 du revêtement 11 peut empêcher la transmission de lumière issue du réflecteur 21. La zone non-revêtue peut permettre cette transmission et ainsi la fonction d'éclairage. En figure 1, on peut observer cette pièce 1 isolée, qui forme à la fois l'enjoliveur du projecteur et un écran de sortie d'un module de signalisation, tel qu'un indicateur de direction, un feu de position et/ou un feu de circulation diurne.

Selon un exemple, le revêtement est disposé sur la face intérieure du de la pièce 1 pour être protégé d'éventuels chocs et intempéries. Ainsi, la durée de vie du revêtement 11, et par conséquent de la pièce 1, peut être augmentée. Selon un autre exemple, le revêtement est disposé sur la face externe de la pièce 1. La pièce 1 peut alors être disposée à l'intérieur d'un ensemble, par exemple d'un ensemble étanche. Le revêtement peut alors être protégé d'éventuels chocs et intempéries. Lorsque la pièce 1 est comprise dans, voire forme, le dioptre de sortie du dispositif lumineux 2, il est préférable que le revêtement soit disposé sur la face externe de la pièce 1. Ainsi, on évite que des éléments présents dans l'épaisseur du de la pièce 1 soient visibles. En complément ou en alternative à la disposition de la pièce 1 dans un ensemble, le revêtement peut être recouvert d'une couche protectrice configurée pour résister à d'éventuels chocs et intempéries. Par exemple, cette couche protectrice est un vernis incolore ou teinté.

Le corps 10 de la pièce 1 est maintenant décrit en détail. Le corps 10 est à base d'un polymère, voire de plusieurs polymères. Le polymère peut être choisi parmi le polycarbonate, le polyméthacrylate de méthyle, le polyméthacrylate de butyle, les polypropylènes, les polyamides, les polyéthylènes, les polyéthers, les résines polyester, les époxy, les polyuréthanes, et autres matières thermoplastiques et thermodurcissables, non revêtues ou revêtues au préalable d'une ou plusieurs souscouches polymères, et leurs dérivés. Par exemple, le polycarbonate présente d'excellentes propriétés mécaniques et d'une résistance thermique permettant une utilisation sur une large gamme de température, typiquement entre -100 °C et 130 °C, voire jusqu'à 180 °C pour les polycarbonates de grade « haute température », ce qui est particulièrement avantageux pour une pièce 1 de véhicule automobile. Notons que le corps 10 peut comprendre d'autres matériaux, par exemple une charge et/ou un renfort pour former un composite. Le corps 10 de la pièce 1 peut en outre présenter une forme au moins selon deux dimensions, voire en trois dimensions. Lorsque la pièce 1 est comprise dans, voire forme, le dioptre de sortie du dispositif lumineux 2, le corps 10 est de préférence en trois dimensions.

Selon un exemple, le corps 10 peut être opaque. La surface 100 du corps 10 peut présenter une couleur distincte du revêtement 11 afin de présenter un élément visuel ou un motif par contraste entre la zone non-revêtue 112 sur la surface 100 et la zone opacifiée 111.

En alternative, le corps 10 peut être partiellement transparent, voire transparent. Le revêtement 11 peut former au moins une zone opacifiée 111 et au moins une zone non-revêtue 112. La zone opacifiée 111 permet de bloquer une transmission de lumière à la surface 100 du corps 10, et la zone non-revêtue 112 forme une zone passante permettant une transmission de lumière, et pouvant donc former un dioptre de sortie.

Le corps 10 peut comprendre en outre une charge diffusante, notamment pour former un dioptre de sortie diffusant la lumière transmise.

Le revêtement 11 est maintenant décrit en détail. le revêtement 11 est formé d'au moins une couche mince 110. Le revêtement 11 est configuré pour opacifier au moins une portion 1000 revêtue de la surface 100. De préférence, la portion 1000 revêtue par le revêtement n'est pas visible par un utilisateur, et plus particulièrement sa couleur peut être masquée. Comme illustré en figure 9, la couche mince 110 peut être directement en contact avec la surface 100.

La couche mince 110 est à base de fer et comprend au moins un parmi un oxyde de fer et un nitrure de fer. L'oxyde de fer et/ou le nitrure de fer, de couleur noire, permet de foncer la couche 110 et ainsi de l'opacifier efficacement par rapport à une couche à base de fer non oxydé ni nitruré, d'aspect métallique.

Le revêtement 11 est plus particulièrement configuré pour opacifier la pièce 1 majoritairement par absorption de lumière, plutôt que par réflexion comme c'est le cas dans les solutions existantes d'opacification de pièces par blanchiment ou par effet miroir. Pour cela, le revêtement 11 peut être configuré pour présenter une absorption d'un rayonnement incident sensiblement supérieure à 70 %. Le rayonnement incident appartient plus particulièrement au domaine du visible. Selon un exemple, le revêtement présente une absorption d'un rayonnement incident sensiblement supérieure à 80 %. Ainsi, le revêtement présente une teinte grise avec une opacification satisfaisante de la pièce 1. Selon un exemple, le revêtement présente une absorption d'un rayonnement incident sensiblement supérieure à 90 %. Ainsi, le revêtement présente une teinte noire avec une opacification satisfaisante de la pièce 1. Selon un exemple alternatif ou complémentaire, le revêtement 11 peut être configuré pour présenter une réflexion du rayonnement lumineux incident sensiblement inférieure à 30%, préférablement sensiblement inférieure à 20% et plus préférentiellement encore sensiblement inférieure à 10%.

La couleur du revêtement 11 peut être décrite dans l'espace chromatique L*a*b* CIE 1976, généralement utilisé pour la caractérisation des couleurs de surface. Dans cet espace, trois paramètres caractérisent les couleurs : la clarté L* décrit la luminance de la surface ; les deux paramètres a* et b* expriment l'écart de la couleur par rapport à celle d'une surface grise de même clarté. De préférence :
- L* est compris entre 20 et 55, et de préférence entre 25 et 50,
- a* est compris entre -5 et +5,
- b* est compris entre -5 et +5.

Le revêtement 11 présente ainsi une couleur grise à noire, assurant une opacification efficace de la portion 1000 revêtue. Par exemple, L* est sensiblement égal à 30, ce qui correspond à une couleur noire. Selon un autre exemple, L* est sensiblement égal à 45, ce qui correspond à une couleur grise, et plus particulièrement gris anthracite. Une méthode de mesure de la couleur du revêtement 11 dans l'espace chromatique L*a*b* CIE 1976 consiste à utiliser un spectrocolorimètre en contact sur le revêtement. Les valeurs de L*, a* et b* sont mesurées par le spectrocolorimètre. On peut par exemple utiliser un spectrocolorimètre CM-700 ou CM-2600 de Konica Minolta ^{©}.

Le revêtement 11 présente une épaisseur E supérieure ou égale à 100 nm sur au moins 50 % de la portion 1000 revêtue. Ainsi, la couche présente, une épaisseur suffisante pour assurer une bonne opacification de la portion 1000 revêtue, et ce sur une majorité de cette portion 1000. En outre, cette épaisseur permet d'assurer une bonne opacification pour un ensemble de pièces 1, malgré une éventuelle variation de l'épaisseur entre les pièces 1 lors du dépôt de la couche 110, décrit ultérieurement. Le revêtement 11 d'opacification est donc fiable et reproductible. L'épaisseur E du revêtement 11 peut plus particulièrement être supérieure ou égale à 200 nm sur au moins 30 % de la portion 1000 revêtue. La couche 110 assure ainsi mieux encore l'opacification de la portion 1000 revêtue. L'épaisseur E du revêtement peut être inférieure ou égale à 1 µm, et de préférence inférieure ou égale à 600 nm, pour minimiser le coût associé à l'élaboration du revêtement 11.

D'autres caractéristiques du revêtement 11 sont ultérieurement décrites dans la description du procédé de fabrication de la pièce 1.

Le procédé de fabrication de la pièce 1 est maintenant décrit en référence aux figures 3 à 9.

Comme illustré en figure 3, le procédé comprend une fourniture d'un corps 10 selon les caractéristiques précédemment décrites.

Le procédé comprend ensuite au moins un dépôt d'une couche mince 110, pour obtenir une couche 110 comprenant au moins un parmi un oxyde de fer et un nitrure de fer. Pour cela, la couche 110 peut être formée par oxydation et/ou nitruration de fer. Par exemple, le fer peut être issu d'une source métallique à base de fer évaporée lors du dépôt, et la couche 110 peut être formée par condensation du métal après oxydation et/ou nitruration. La source métallique peut être du fer pur ou un alliage de fer, et plus particulièrement tout type d'acier, y compris de l'acier inoxydable.

Pour permettre l'oxydation et/ou la nitruration, le dépôt peut être effectué dans une atmosphère comprenant au moins un gaz propre à régir au moins avec le fer, désigné de façon équivalente comme gaz réactif. Le gaz réactif peut être dilué dans un gaz ne réagissant pas lors du dépôt, désigné de façon équivalente comme gaz inerte, tel que l'argon par exemple Le gaz réactif peut être choisi parmi le dioxygène, pour une réaction d'oxydation, et le diazote, pour une réaction de nitruration.

Selon un exemple, le gaz réactif est du dioxygène, éventuellement en mélange avec du diazote et/ou dilué dans un gaz inerte. L'atmosphère peut comprendre du dioxygène à un taux compris entre 10 % et 100 %, et de préférence entre 20 % et 80 %. Selon le taux de dioxygène, la réaction d'oxydation entre le fer et le dioxygène peut être modulée.

Une réduction de la teneur en dioxygène induit une réaction moindre avec le fer, ce qui permet de réduire la concentration en oxyde de fer dans la couche 110 et obtenir une couleur grise. En outre, la réduction de la teneur en dioxygène permet de s'affranchir d'un risque d'explosion lié au dioxygène. Le taux d'oxygène peut par exemple être compris entre 10 et 25 %, et de préférence entre 20 et 25%, pour obtenir un revêtement 11 de couleur grise. Le gaz réactif peut être un mélange de dioxygène et du diazote, dans lequel le taux d'oxygène peut être sensiblement égal à 20 %. Le gaz réactif est par exemple de l'air, minimisant ainsi le coût du revêtement 11 et de l'équipement de dépôt.

En augmentant la teneur en dioxygène, la réaction d'oxydation du fer est favorisée, ce qui permet d'augmenter la concentration en oxyde de fer dans la couche 110. Le taux de dioxygène dans l'atmosphère peut être compris entre 25 % et 100 %, et de préférence entre. 25 % et 80 % pour obtenir un revêtement 11 de couleur noire. En effet, entre 80% et 100% d'oxygène, l'atmosphère peut être très réactive et induire des reflets colorés jaunes, rouges ou bleus. Afin d'éviter un éventuel risque d'explosion induite par une teneur en dioxygène supérieure à 25 %, l'équipement de dépôt peut comprendre un groupe de sécurité, par exemple un groupe de pompage sec.

Le temps de dépôt et la pression de l'atmosphère peuvent être configurés pour moduler l'épaisseur de la couche 110 déposée. Durant le dépôt, la pression peut être comprise entre 10⁻⁴ mbar et 10⁻¹ mbar, et de préférence entre 10⁻³ mbar et 10⁻² mbar (avec 1 mbar = 10⁻³ bar = 100 Pa dans le système international des unités). Une pression supérieure à ces gammes peut notamment entrainer des inhomogénéités dans la couche 110, et former un dépôt rugueux donnant un aspect poudreux au revêtement. Une pression inférieure à cette gamme peut en outre ne pas être suffisante pour permettre la réaction entre le fer et le gaz réactif, et ainsi donner un aspect métallique à la couche 110. Notons que ces paramètres peuvent être ajustés selon la technique de dépôt employée. Une pression comprise entre 10⁻⁴ mbar et 10⁻¹ mbar est particulièrement adapté à un dépôt par un dépôt physique en phase vapeur par faisceau d'électrons. Une pression comprise entre 10⁻³ mbar à 10⁻² mbar est particulièrement adapté pour un dépôt par évaporation thermique assisté par plasma et par pulvérisation cathodique.

Comme illustré sur les figures 4 à 6, la couche 110 peut être déposée sur une surface 100 supérieure du corps 10. Notons que la couche 110 peut en outre être déposée sur des surfaces 100 latérales du corps 10. En outre, le corps 10 pouvant présenter une forme en trois dimensions, par exemple présentant des reliefs de matière, la couche 110 peut être déposée sur la surface 100 en suivant sa forme en trois dimensions. Selon la technique de dépôt employée, la couche 110 peut être conforme ou non conforme. Par « conforme », on entend que la couche présente, aux tolérances de fabrication près, une épaisseur identique malgré les changements de direction de la couche 110. Lorsque la couche 110 est non conforme, son épaisseur peut varier entre différentes sections de la couche. On comprend dès lors qu'une partie seulement de la couche 110 peut présenter l'épaisseur E précédemment décrite.

Le procédé peut comprendre le dépôt d'une pluralité de couches minces 110, 110'. Selon l'exemple illustré en figure 6, les paramètres de dépôt peuvent notamment être adaptés pour moduler la concentration en oxyde de fer et/ou en nitrure de fer dans la couche mince 110 entre les différentes couches 110, 110'. De façon alternative ou complémentaire, le dépôt de la couche mince 110 peut en outre être configuré de sorte que la couche 110 présente un gradient de concentration en oxyde de fer et/ou en nitrure de fer dans la couche mince 110. La couche 110 peut notamment présenter un gradient de concentration selon une direction perpendiculaire à la surface 100 du corps.

Afin de former la zone opacifiée 111 et la zone non-revêtue 112, le procédé peut comprendre au moins une parmi une application d'un masque 3 partiel de la surface 100 préalablement au dépôt de la couche mince 110, et une ablation laser d'une portion 112' de la couche mince 110 déposée.

Comme illustré en figure 7, la couche 110 déposée peut être soumise à un rayonnement laser pour graver la couche 110. Le rayonnement laser peut être configuré de façon à graver une portion 112' de la couche 110 sur une portion 1001 de la surface 100. Ainsi, la portion 1001 de la surface peut être totalement non-revêtue, comme illustrée en figure 9. Selon un exemple non illustré, le rayonnement laser peut être configuré de sorte que la gravure de la couche 110 soit partielle, par exemple pour obtenir une variation progressive de l'épaisseur E de la couche 110 entre une zone non-revêtue 112 et une zone opacifiée 111. La puissance du rayonnement laser et le temps d'ablation peuvent notamment être adaptés pour cela.

Comme illustré en figure 8A, le procédé peut comprendre l'application d'un masque 3 sur une portion 1001 de la surface 100, destinée à être non revêtue. Le dépôt de la couche 110 peut alors être effectué sur l'ensemble formé par le corps 10 et le masque 3, comme illustré en figure 8B. Par retrait du masque partiel 3, la zone opacifiée 111 et la zone non-revêtue 112 sont formées, comme l'illustre le passage de la figure 8B à la figure 9.

La couche 110 peut être déposée par une technique de dépôt physique en phase vapeur. La couche 110 peut être déposée par évaporation thermique assistée par plasma. Le dépôt par évaporation thermique est rapide et donc particulièrement adapté pour un dépôt de couche mince de grande épaisseur. Le plasma permet en outre la réaction d'oxydation et/ou de nitruration entre le fer et l'atmosphère réactive. Lors du dépôt par évaporation thermique assisté par plasma, les premières couches atomiques déposées peuvent présenter une concentration en fer plus importante que la concentration en oxygène, voire en oxygène et azote le cas échéant. Au fur et à mesure du dépôt, la concentration en fer et la concentration en élément oxygène, et azote le cas échéant, peuvent s'équilibrer pour atteindre les proportions stoechiométriques de l'oxyde et/ou du nitrure de fer, et ainsi former un gradient de concentration dans la couche 110, selon une direction perpendiculaire à la surface 100 du corps 10.

La couche 110 peut être déposée par dépôt physique en phase vapeur par faisceau d'électrons. En fonction de la puissance du faisceau d'électrons, le dépôt physique en phase vapeur par faisceau d'électrons permet de moduler la vitesse de dépôt de la couche mince, et ainsi les caractéristiques de la couche obtenue. Par exemple, une première couche 110 peut être déposée à une vitesse rapide. La réaction d'oxydation ou de nitruration du fer peut alors être incomplète. La couche 110 peut alors présenter une concentration en fer plus importante que la concentration en oxygène, voire en oxygène et azote le cas échéant. Une deuxième couche 110 peut ensuite être déposée à plus faible vitesse pour obtenir une couche 110 de finition présentant une bonne stoechiométrie et ainsi assurer l'opacification par le revêtement 11.

La couche 110 peut être déposée par pulvérisation cathodique réactive. Le dépôt par pulvérisation atomique est rapide et donc particulièrement adapté pour un dépôt de couche mince de grande épaisseur. Par ailleurs, la couche mince obtenue 110 peut présenter une meilleure adhérence du fait que les ions créés lors de la pulvérisation cathodique ont une énergie suffisante pour s'implanter légèrement dans la surface 100 du corps 10. En outre, par cette technique, la couche mince 110 conserve la stoechiométrie des éléments du matériau source, permettant ainsi de moduler les caractéristiques de la couche obtenue. Selon un exemple, la couche est déposée par pulvérisation cathodique magnétron. La source métallique est alors une source amagnétique, et par exemple de l'acier inoxydable. De par la présence de chrome dans la source métallique, la réaction entre le fer et l'oxygène est limité ce qui induit une couleur grise du revêtement 11.

À titre d'exemple, un mode opératoire du procédé est maintenant décrit, dans lequel le dépôt de la couche mince est réalisé par évaporation thermique assisté par plasma, dans laquelle :
- l'évaporation thermique est réalisée sous une tension comprise entre 1 V et 10 V, de préférence entre 3 V et 7 V, et à un courant compris entre 100 A to 10 000 A, de préférence sensiblement compris entre 500 A et 3000 A,
- le plasma est alimenté par un courant continu, soit par un courant alternatif de moyenne fréquence, par exemple 40 kHz, ou bien radiofréquence, ou par des micro-ondes. Lorsque le plasma est alimenté par un courant continu, ou par un courant alternatif de moyenne fréquence, par exemple 40 kHz, le plasma est sous une tension comprise entre 500 V et 10 000 V, de préférence entre 2000 V et 6000 V, et à un courant compris entre 0 mA et 5000 mA, de préférence entre 50 mA et 1000 mA,
- la durée d'évaporation est comprise entre 50 secondes (s) et 1000 s, de préférence entre 150 s et 400 s,
- la pression est comprise entre 10⁻⁴ mbar et 10⁻¹ mbar, de préférence entre 10⁻³ mbar et 10⁻² mbar.

Au vu de la description qui précède, il apparaît clairement que l'invention propose une pièce de véhicule automobile comprenant un revêtement d'opacification amélioré, fiable et reproductible.

L'invention n'est pas limitée aux modes de réalisations précédemment décrits et s'étend à tous les modes de réalisation couverts par les revendications.

### LISTE DES REFERENCES NUMERIQUES

1 Pièce
10 Corps
100 Surface
1000 Portion à opacifier
1001 Portion non revêtue
11 Revêtement d'opacification
110 Couche mince
110' Deuxième couche mince
111 Zone opacifiée
112 Zone non-revêtue
112' Portion de la couche mince
12 Élément d'accroche
2 Dispositif lumineux
20 Source de lumière
21 Réflecteur
22 Dioptre de sortie
3 Masque

## Revendications

1. Pièce (1) de véhicule automobile comprenant :
• un corps (10) à base d'un polymère présentant une surface (100),
• un revêtement (11) d'opacification recouvrant au moins une portion (1000) de la surface (100), et
**caractérisée en ce que** le revêtement :
• est formé d'au moins une couche mince (110) à base de fer et comprenant au moins un parmi un oxyde de fer et un nitrure de fer, et
• présente une épaisseur (E) supérieure ou égale à 100 nm sur au moins 50 % de l'au moins une portion (1000) de la surface (100)
• présente une absorption d'un rayonnement lumineux incident supérieure à 70% du rayonnement lumineux incident.

2. Pièce (1) selon la revendication précédente, dans laquelle le revêtement (11) d'opacification est configuré de sorte à former au moins une zone opacifiée (111) au niveau de l'au moins une portion (1000) de la surface (100), et au moins une zone non-revêtue (112).

3. Pièce (1) selon l'une quelconque des revendications précédentes, dans laquelle le revêtement (11) d'opacification présente une épaisseur (E) supérieure ou égale à 200 nm sur au moins 30 % de l'au moins une portion (1000) de la surface (100).

4. Pièce (1) selon l'une quelconque des revendications précédentes, dans laquelle le revêtement (11) d'opacification présente une épaisseur (E) inférieure ou égale à 1 µm.

5. Pièce (1) selon l'une quelconque des revendications précédentes, dans laquelle le corps (10) est au moins partiellement transparent.

6. Pièce (1) selon l'une quelconque des revendications précédentes dans laquelle le revêtement (11) d'opacification présente, sur au moins 50 % de l'au moins une portion (1000) de la surface (100), une couleur dans l'espace chromatique L*a*b*CIE 1976 défini par les paramètres L*, a* et b*, où :
• L* est compris entre 20 et 55,
• a* est compris entre -5 et +5,
• b* est compris entre -5 et +5.

7. Dispositif lumineux (2) de véhicule automobile comprenant une pièce (1) de véhicule automobile selon l'une quelconque des revendications 1 à 6, et une source de lumière (20), pour au moins une fonction choisie parmi une fonction d'éclairage et une fonction de signalisation.

8. Dispositif lumineux (2) selon la revendication précédente, dans lequel le corps (10) est au moins partiellement transparent, et le revêtement (11) d'opacification est configuré pour former au moins une zone opacifiée (111) au niveau de l'au moins une portion (1000) de la surface (100), et au moins une zone non-revêtue (112), et dans lequel la zone non-revêtue (112) forme un dioptre de sortie (22) de lumière.

9. Procédé de fabrication d'une pièce (1) de véhicule automobile selon l'une quelconque des revendications 1 à 6 comprenant :
• une fourniture d'un corps (10) à base d'un polymère présentant une surface (100),
• au moins un dépôt d'une couche mince (110) à base de fer en atmosphère comprenant au moins un gaz réactif choisi parmi le dioxygène, le diazote, sur au moins une portion à opacifier (1000) de la surface (10), de sorte que la couche mince (110) comprend au moins un parmi un oxyde de fer et un nitrure de fer, et présente une épaisseur (E) supérieure à 100 nm sur au moins 50 % de l'au moins une portion de la surface, pour former un revêtement (11) d'opacification

10. Procédé selon la revendication précédente, le procédé comprenant en outre au moins une étape parmi :
• une application d'un masque (3) partiel de la surface (100) préalablement au dépôt de la couche mince (110), suivi d'un retrait du masque (3) après le dépôt de la couche mince (110), et
• une ablation laser d'une portion (112') de la couche mince (110) déposée.

11. Procédé selon l'une quelconque des revendications 9 et 10, dans lequel le dépôt de la couche mince (110) est effectué à une pression comprise entre 10⁻⁴ mbar et 10⁻¹ mbar.

12. Procédé selon l'une quelconque des revendications 9 à 11, dans lequel l'atmosphère comprend du dioxygène à un taux compris entre 10 % et 100 %, et de préférence entre 20 % et 80 %.

13. Procédé selon l'une quelconque des revendications 9 à 11, dans lequel l'atmosphère comprend du dioxygène à un taux compris entre 10 % et 25 %, et de préférence entre 20 % et 25 %.

14. Procédé selon l'une quelconque des revendications 9 à 11, dans lequel l'atmosphère comprend du dioxygène à un taux compris entre 25 % et 100 %, et de préférence entre 25 % et 80 %.

15. Procédé selon l'une quelconque des revendications 9 à 14, dans lequel le dépôt de la couche mince (110) est un dépôt physique en phase vapeur choisi parmi :
• un dépôt par évaporation thermique assisté par plasma,
• un dépôt physique en phase vapeur par faisceau d'électrons,
• un dépôt par pulvérisation cathodique.

## Patentansprüche

1. Teil (1) eines Kraftfahrzeugs, umfassend:
• einen Körper (10) auf Basis eines Polymers, der eine Oberfläche (100) aufweist,
• eine Trübungsbeschichtung (11), die mindestens einen Abschnitt (1000) der Oberfläche (100) bedeckt, und
**dadurch gekennzeichnet, dass** die Beschichtung:
• aus mindestens einer dünnen Schicht (110) auf Basis von Eisen und umfassend mindestens eines unter einem Eisenoxid und einem Eisennitrid gebildet ist, und
• eine Dicke (E) größer oder gleich 100 nm auf mindestens 50 % des mindestens einen Abschnitts (1000) der Oberfläche (100) aufweist
• eine Absorption einer einfallenden Lichtstrahlung von mehr als 70 % der einfallenden Lichtstrahlung aufweist.

2. Teil (1) nach dem vorhergehenden Anspruch, wobei die Trübungsbeschichtung (11) so ausgestaltet ist, dass mindestens ein getrübter Bereich (111) an dem mindestens einen Abschnitt (1000) der Oberfläche (100) und mindestens ein nicht beschichteter Bereich (112) gebildet werden.

3. Teil (1) nach einem der vorhergehenden Ansprüche, wobei die Trübungsbeschichtung (11) eine Dicke (E) größer oder gleich 200 nm auf mindesten 30 % des mindestens einen Abschnitts (1000) der Oberfläche (100) aufweist.

4. Teil (1) nach einem der vorhergehenden Ansprüche, wobei die Trübungsbeschichtung (11) eine Dicke (E) kleiner oder gleich 1 µm aufweist.

5. Teil (1) nach einem der vorhergehenden Ansprüche, wobei der Körper (10) mindestens teilweise transparent ist.

6. Teil (1) nach einem der vorhergehenden Ansprüche, wobei die Trübungsbeschichtung (11) auf mindestens 50 % des mindestens einen Abschnitts (1000) der Oberfläche (100) eine Farbe in dem durch die Parameter L*, a* und b* definierten Farbraum L*a*b*CIE 1976 aufweist, worin:
• L* zwischen 20 und 55 beträgt,
• a* zwischen -5 und +5 beträgt,
• b* zwischen -5 und +5 beträgt.

7. Leuchtvorrichtung (2) eines Kraftfahrzeugs, umfassend ein Teil (1) eines Kraftfahrzeugs nach einem der Ansprüche 1 bis 6 und eine Lichtquelle (20) für mindestens eine unter einer Beleuchtungsfunktion und einer Signalisierungsfunktion gewählte Funktion.

8. Leuchtvorrichtung (2) nach dem vorhergehenden Anspruch, wobei der Körper (10) mindestens teilweise transparent ist und die Trübungsbeschichtung (11) dazu ausgestaltet ist, mindestens einen getrübten Bereich (111) an dem mindestens einen Abschnitt (1000) der Oberfläche (100)und mindestens einen nicht beschichteten Bereich (112) zu bilden, und wobei der nicht beschichtete Bereich (112) einen Austrittsdiopter (22) für Licht bildet.

9. Verfahren zur Herstellung eines Teils (1) eines Kraftfahrzeugs nach einem der Ansprüche 1 bis 6, umfassend:
• ein Bereitstellen eines Körpers (10) auf Basis eines Polymers, der eine Oberfläche (100) aufweist,
• mindestens ein Abscheiden einer dünnen Schicht (110) auf Basis von Eisen in einer Atmosphäre, die mindestens ein unter Disauerstoff, Distickstoff gewähltes reaktives Gas umfasst, auf mindestens einem zu trübenden Abschnitt (1000) der Oberfläche (10), so dass die dünne Schicht (110) mindestens eines unter einem Eisenoxid und einem Eisennitrid umfasst und eine Dicke (E) von mehr als 100 nm auf mindestens 50 % des mindestens einen Abschnitts der Oberfläche aufweist, um eine Trübungsbeschichtung (11) zu bilden.

10. Verfahren nach dem vorhergehenden Anspruch, wobei das Verfahren ferner mindestens einen Schritt umfasst unter:
• einem Applizieren einer partiellen Blende (3) der Oberfläche (100) vor dem Abscheiden der dünnen Schicht (110), gefolgt von einem Entfernen der Blende (3) nach dem Abscheiden der dünnen Schicht (110), und
• einer Laserablation eines Abschnitts (112') der abgeschiedenen dünnen Schicht (110).

11. Verfahren nach einem der Ansprüche 9 und 10, wobei das Abscheiden der dünnen Schicht (110) bei einem Druck zwischen 10⁻⁴ mbar und 10⁻¹ mbar erfolgt.

12. Verfahren nach einem der Ansprüche 9 bis 11, wobei die Atmosphäre Disauerstoff mit einem Anteil zwischen 10 % und 100 % und bevorzugt zwischen 20 % und 80 % umfasst.

13. Verfahren nach einem der Ansprüche 9 bis 11, wobei die Atmosphäre Disauerstoff mit einem Anteil zwischen 10 % und 25 % und bevorzugt zwischen 20 % und 25 % umfasst.

14. Verfahren nach einem der Ansprüche 9 bis 11, wobei die Atmosphäre Disauerstoff mit einem Anteil zwischen 25 % und 100 % und bevorzugt zwischen 25 % und 80 % umfasst.

15. Verfahren nach einem der Ansprüche 9 bis 14, wobei das Abscheiden der dünnen Schicht (110 eine physikalische Gasphasenabscheidung ist, die gewählt ist unter:
• einer plasmagestützten thermischen Verdampfung,
• einer physikalischen Gasphasenabscheidung durch Elektronenstrahl,
• einer Abscheidung durch Sputtern.

## Claims

1. Automotive vehicle component (1) comprising:
• a polymer-based body (10) having a surface (100);
• an opacification coating (11) covering at least one portion (1000) of the surface (100); and
**characterized in that** the coating:
• is formed of at least one iron-based thin film (110) comprising at least one compound from among an iron oxide and an iron nitride; and
• has a thickness (E) of greater than or equal to 100 nm over at least 50% of the at least one portion (1000) of the surface (100);
• exhibits an incident light radiation absorption of greater than 70% of the incident light radiation.

2. Component (1) according to the preceding claim, wherein the opacification coating (11) is configured so as to form at least one opacified area (111) on the at least one portion (1000) of the surface (100), and at least one uncoated area (112).

3. Component (1) according to either one of the preceding claims, wherein the opacification coating (11) has a thickness (E) of greater than or equal to 200 nm over at least 30% of the at least one portion (1000) of the surface (100).

4. Component (1) according to any one of the preceding claims, wherein the opacification coating (11) has a thickness (E) of less than or equal to 1 µm.

5. Component (1) according to any one of the preceding claims, wherein the body (10) is at least partially transparent.

6. Component (1) according to any one of the preceding claims, wherein the opacification coating (11) has, over at least 50% of the at least one portion (1000) of the surface (100), a colour in the 1976 CIE L*a*b* colour space defined by the parameters L*, a* and b*, where:
• L* is between 20 and 55;
• a* is between -5 and +5;
• b* is between -5 and +5.

7. Automotive vehicle luminous device (2) comprising an automotive vehicle component (1) according to any one of Claims 1 to 6, and a light source (20), for at least one function selected from among a lighting function and a signalling function.

8. Luminous device (2) according to the preceding claim, wherein the body (10) is at least partially transparent, and the opacification coating (11) is configured to form at least one opacified area (111) on the at least one portion (1000) of the surface (100), and at least one uncoated area (112), and wherein the uncoated area (112) forms a light exit diopter (22).

9. Method for manufacturing an automotive vehicle component (1) according to any one of Claims 1 to 6, comprising:
• supplying a polymer-based body (10) having a surface (100) ;
• at least one deposition of an iron-based thin film (110) in an atmosphere comprising at least one reactive gas selected from among dioxygen, dinitrogen, on at least one portion to be opacified (1000) of the surface (10), such that the thin film (110) comprises at least one compound from among an iron oxide and an iron nitride, and has a thickness (E) of greater than 100 nm over at least 50% of the at least one portion of the surface, in order to form an opacification coating (11).

10. Method according to the preceding claim, the method further comprising at least one step from among:
• applying a partial mask (3) to the surface (100) prior to the deposition of the thin film (110), followed by removing the mask (3) after the thin film (110) has been deposited; and
• laser ablation of a portion (112') of the deposited thin film (110).

11. Method according to either one of Claims 9 and 10, wherein the thin film (110) is deposited at a pressure of between 10⁻⁴ mbar and 10⁻¹ mbar.

12. Method according to any one of Claims 9 to 11, wherein the atmosphere comprises dioxygen at a content of between 10% and 100%, and preferably between 20% and 80%.

13. Method according to any one of Claims 9 to 11, wherein the atmosphere comprises dioxygen at a content of between 10% and 25%, and preferably between 20% and 25%.

14. Method according to any one of Claims 9 to 11, wherein the atmosphere comprises dioxygen at a content of between 25% and 100%, and preferably between 25% and 80%.

15. Method according to any one of Claims 9 to 14, wherein the deposition of the thin film (110) is a physical vapour deposition selected from among:
• plasma-enhanced thermal evaporation deposition;
• electron-beam physical vapour deposition;
• cathode sputter deposition.
